**Europäisches Patentamt**

**European Patent Office**

**Office européen des brevets**

(11) Veröffentlichungsnummer: **0 461 543 A2**

# EUROPÄISCHE PATENTANMELDUNG

(21) Anmeldenummer: **91109223.7**

(22) Anmeldetag: **06.06.91**

(51) Int. Cl.5: **H01L 21/28**

(30) Priorität: **15.06.90 DE 4019090**

(43) Veröffentlichungstag der Anmeldung:
**18.12.91 Patentblatt 91/51**

(84) Benannte Vertragsstaaten:
**AT BE CH DE DK ES FR GB GR IT LI LU NL SE**

(71) Anmelder: **Battelle-Institut e.V.**
**Am Römerhof 35 Postfach 900 160**
**W-6000 Frankfurt/Main 90(DE)**

(72) Erfinder: **Tschulena, Guido, Dr.**
**Reichenberger Strasse 5**
**W-6393 Wehrheim(DE)**

(54) Verfahren und Vorrichtung zum Beschichten von Substraten mit geschmolzenem Material.

(57) Verfahren und Vorrichtung zur Beschichtung, insbesondere Silizium- oder anderen Halbleiterwafern, in denen in einer auf eine vorbestimmte Temperatur aufgeheizten Spin-Coatingapparatur geschmolzenes Material, insbesondere Metall, auf das auf den vorgeheizten Drehteller der Apparatur fixierte Substrat gebracht wird und die Temperatur des Drehtellers nach erfolgter Ausbreitung des flüssigen Materials zur Hervorrufung einer Erstarrung des Materials abgekühlt wird, wobei sich gegenüber herkömmlichen Beschichtungsverfahren auch größere Schichtdicken ohne Schwierigkeiten und selektiv an bestimmten Stellen aufbringen lassen und Materialien mit beliebiger Schichtdicke insbesondere in den Kanälen oder andersartigen Vertiefungen strukturierter Substrate abscheiden lassen.

EP 0 461 543 A2

Die Erfindung betrifft Verfahren zur Beschichtung von Substraten, insbesondere Silizium- oder anderen Halbleiterwafern mit Materialien, insbesondere Metallen, sowie Vorrichtungen zu deren Durchführung.

Die Beschichtung von Halbleiterwafern, die aus zahlreichen Chips (mehreren hundert bis zu mehreren tausend Stück) bestehen, auf denen jeweils gleiche Strukturen vorgesehen sind, stellt ein wichtiges Aufgabengebiet in der Halbleitertechnologie dar.

Beschichtungen mit typischerweise im Mikrometerbereich liegenden Schichtdicken werden großflächig z.B. durch Vakuumverfahren (Aufdampf- oder Sputterverfahren) oder auch durch galvanische Verfahren großflächig erzielt. Die Strukturierung erfolgt im Fotolithographieprozeß. Dabei wird in der Regel mittels eines Fotolithographieprozesses Fotolack großflächig auf dem Wafer aufgebracht, wobei der Fotolack (im Fall eines positivfotolacks) an vorgegebenen, durch Masken belichtet wird. An den belichteten Stellen läßt er sich wegwaschen und an den unbelichteten Stellen polymerisiert. Anschließend wird Metall aufgedampft, dann der strukturierte Fotolack weggelöst, so daß das strukturierte Metall zurückbleibt. Das Metall kann stattdessen z.B. auch nach dem Verfahren der Kathodenzerstäubung aufgebracht werden.

Die Aufbringung des Fotolacks auf den Halbleiterwafern erfolgt in der Regel nach dem sogenannten Spin-Coatingverfahren. Hierbei wird die zu beschichtende Siliziumscheibe mittels erzeugtem Unterdruck bzw. Vakuum auf einem Drehteller festgehalten und fixiert. Im unbewegten Zustand oder bei geringer Drehzahl des Tellers wird in der Scheibenmitte eine definierte Menge Fotolack aufgebracht. Anschließend wird der Drehteller auf einige tausend Umdrehungen pro Minute beschleunigt, so daß der Lack gleichmäßig über die gesamte Siliziumscheibe verteilt wird und der überschüssige Lack abgeschleudert wird. Es wurden bereits genauere Zusammenhänge zwischen der gewünschten Lackdicke und der einzustellenden Drehzahl untersucht und in entsprechenden Diagrammen festgehalten ("Halbleitersensoren",: Reichl, Expert-Verlag (1989), Ehningen bei Böblingen.

Die DE-OS 38 37 827 beschreibt ein ähnliches Verfahren zum Aufbringen möglichst gleichmäßiger Schichten auf flachen Anzeigeschirmen, wobei dafür gesorgt wird, daß vor dem Einsetzen der Rotation des Drehtellers die gesamte zu beschichtende Oberfläche bereits mit dem Beschichtungsmaterial benetzt ist. Auf diese Weise wird vermieden, daß in Folge der Viskosität eine Verdickung zu den Substraträndern hin auftritt. Eine eventuelle Erhitzung oder Belichtung zu Aushärtungszwecken erfolgt nach Beendigung des Abschleudervorgangs und der Schichtausbildung.

Um dickere Schichten bzw. Strukturen und insbesondere Metallschichten auf Halbleitersubstraten über einen Bereich von mehreren Mikrometern bis zu weit über 10 $\mu$m und bis hin zu einigen 100 $\mu$m zu erzielen, wird ferner die strukturierte dünne Schicht allgemein häufig durch eine selektive galvanische Abscheidung auf den Strukturen verstärkt.

Diese Beschichtungs- und Strukturierungsverfahren sind in der Halbleitertechnologie zu weitestgehender Perfektion vervollkommnet worden. Diese Perfektion ist jedoch nur bei Schichtdicken im Bereich weniger Mikrometer erzielbar. Bei größeren Schichtdicken sind zudem die Beschichtungs und Ätzprozesse langwierig und zeit- und kostenaufwendig. Darüberhinaus treten Schwierigkeiten auf, wenn tiefe Halbleiterstrukturen beschichtet werden sollen. Derartige Beschichtungen werden jedoch in Zukunft im Hinblick auf die neuere Entwicklung der Nutzung mikromechanischer Verfahren zur Herstellung dreidimensionaler Strukturen in Siliziumbauelementen in großem Umfang erforderlich sein.

Diese mikromechanischen Verfahren umfassen die bereits erwähnten Fotolithographieverfahren zur Herstellung von Oberflächenstrukturen, deren laterale Dimension typischerweise vom Submikrometerbereich bis zu einigen 100 $\mu$m oder auch einigen 1000 $\mu$m erstrecken. Dabei ist neben weiteren Materialien insbesondere Silizium betroffen. Ferner kommen Verfahren zur Tiefenstrukturierung hinzu, um dreidimensionale Gebilde mit Tiefendimensionen im Bereich von einigen Millimetern bis Mikrometern zu gewinnen. Diese Verfahren zur Tiefenstrukturierung umfassen insbesondere anisotrope Ätzverfahren, bei denen die Abhängigkeit der Ätzrate von der kristallographischen Orientierung ausgenutzt wird. Dabei können zwischen "schnell" ätzenden Orientierungen und den "langsam" ätzenden 111-Orientierungen Ätzratenverhältnisse von bis zu 1:100 erreicht werden. Ein weiteres Verfahren zur Tiefenstrukturierung betrifft den Einsatz hochdotierter Ätzstoppschichten oder an p-n-Übergängen elektrochemisch gesteuerter Ätzverfahren.

An dreidimensionalen Strukturen in Silizium und anderen Materialien (z.B. Galliumarsenid, Quarz, Polymeren) werden dreidimensionale Strukturen gefertigt, wie sie im Prospekt "Mikromechanik", Battelle-Institut, 1990, zusammengestellt sind. Hierzu gehören einfache Strukturen wie Gitter, Siebe, Löcher, Membranen für Drucksensoren, Spitzen z.B. für biomedizinische Elektroden usw.. Ferner sind Sensoren (wie Drucksensoren, Vibrationssensoren und Gassensoren), thermische Anemometer, usw. umfaßt. Neben Aktoren wie Relais, Schalter, Lichtablenkern und Durchflußreglern erstreckt sich diese Fertigungsart bis hin zu ganzen Mikrosystemen wie miniaturisierten Gaschromatographen oder Mikromotoren sowie auch Chip-Kühlsystemen.

In einigen der genannten Strukturen besteht der Bedarf, Kanäle auszubilden und diese Kanäle mit Metallschichten oder anderen Materialien zu füllen. Insbesondere dann, wenn tiefe Kanäle etwa mit Tiefen im Bereich einiger 100 μm, die zu füllen sind, vorliegen, ergeben sich bei den geschilderten herkömmlichen Verfahren große Schwierigkeiten, da diese ganzflächig erfolgen und ferner eine nachfolgende Fotolithographie auf einer strukturierten Oberfläche fast nicht möglich ist. Darüberhinaus sind nur dünne Schichten ökonomisch abscheidbar.

Der Erfindung liegt die Aufgabe zugrunde, ein Beschichtungsverfahren für Substrate, insbesondere Silizium- oder andere Halbleiterwafer anzugeben, mit dem sich auch größere Schichtdicken ohne Schwierigkeiten und selektiv an bestimmten Stellen aufbringen lassen und Materialien mit beliebiger Schichtdicke insbesondere in den Strukturen strukturierter Substrate abgeschieden werden können.

Diese Aufgabe wird durch den Gegenstand des Patentanspruchs 1 bzw. 7 gelöst.

Dabei werden die Beschichtungsmaterialien über ihren Schmelzpunkt erhitzt und dann im flüssigen Zustand in einer geheizten Spin-Coating-Apparatur auf beliebige Substrate aufgeschleudert. Durch die erhöhte Temperatur des Drehtellers können die Viskositätsprobleme weitestgehend beseitigt werden und es ist möglich, auch die gewünschten dicken Schichten fast ohne Randverdickung herzustellen, ohne vorher z.B. die gesamte Substratoberfläche zu benetzen. Ferner sind z.B. Metallschichten nur auf bestimmten Stellen, etwa dort, wo sich bedingt durch Wahl unterschiedlicher Materialien Haftvermittlerschichten befinden oder durch Strukturierungen der Oberfläche bessere Benetzungs- und Beschichungsbedingungen vorliegen, aufbringbar. Insbesondere in Vertiefungen lassen sich dann beliebig große Schichtdicken abscheiden.

Das nach dem Stand der Technik bekannte Spin-Coatingverfahren bzw. die entsprechende Apparatur, die bisher z.B. zur Beschichtung von Wafern mit Fotolack verwendet wurden, sind erfindungsgemäß zu einem Hochtemperatur-Spin-Coatingverfahren bzw. einer Hochtemperatur-Spin-Coating-Apparatur modifiziert. Durch diese verhältnismäßig einfache Modifizierung, die aus einer Integration eines Heizers in den Drehteller besteht, sowie in dem Hinzufügen eines Vorratsgefäßes und entsprechender Leitungen, können in überraschend einfacher Weise die obigen Merkmale erzielt werden.

Metalle, Gläser und andere Materialien sind mit dieser Integration von Heizern oder Heizeinrichtungen in den flüssigen Zustand überführbar und werden in der flüssigen Phase auf das zu beschichtende Substrat, z.B. in Form eines strukturierten oder beschichteten Siliziumwafers gebracht. Dabei reichen wenige Tropfen des flüssigen Materials aus. Abhängig vom Verhältnis zwischen der Oberflächenspannung der Materialien, den Benetzungsverhältnissen an der Substratoberfläche und der Drehzahl des geheizten Drehtellers stellt sich eine gleichmäßig dicke Schicht ein. Die Dicke der Schicht ist durch die Drehzahl regelbar.

Sobald eine gleichmäßig dicke Schicht aufgebracht ist, wird die Temperatur des Drehtellers bis unter den Schmelzpunkt des Materials reduziert. Die Schicht erstarrt. Abhängig von der Benetzung der Materialschicht mit dem Untergrund, d.h. der Substratoberfläche, kann die Materialschicht, insbesondere Metallschicht, auch ohne weiteres gezielt strukturiert abgeschieden werden und kristallisiert in der Regel dann aus.

Ferner lassen sich tiefe Kanäle strukturierter Substrate bzw. Halbleiterwafer mit Metall- oder anderen Materialschichten füllen, wobei der Füllungsgrad durch die Umdrehungszahl steuerbar ist. Durch die Oberflächenspannung zieht sich die jeweilige Schmelzflüssigkeit gleichmäßig in die Kanäle zurück, wenn das Substrat sich abkühlt, und erstarrt dort.

Somit eignet sich die Erfindung zur Beschichtung einer Vielzahl unterschiedlicher Substrate und erbringt insbesondere für stark strukturierte Wafer gegenüber den bisherigen Verfahren erhebliche Vorteile.

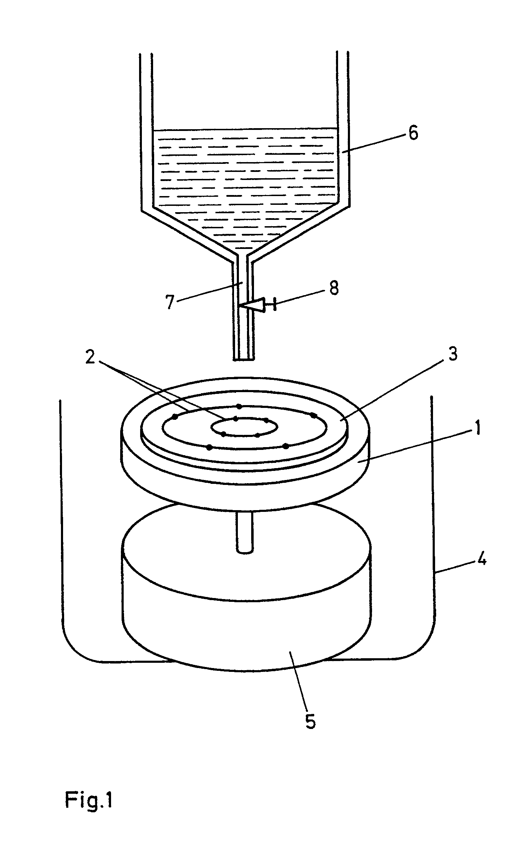

Im folgenden wird die Erfindung anhand der Figur näher erläutert, die ein Ausführungsbeispiel für eine Vorrichtung zur Durchführung des erfindungsgemäßen Verfahrens zeigt.

Diese Vorrichtung umfaßt einen Drehteller 1, der im Gegensatz zu den bekannten Spin-Coating-Apparaturen geheizt ist. Dies ist z.B. leicht durch eine in den Drehteller integrierte Heizspirale realisierbar. Als alternative Lösung ist eine Heizung durch Infrarotstrahlung von oben möglich. In der Drehtelleroberseite sind Rillen und Löcher 2 zur Unterdruckerzeugung vorgesehen, um eine auf den Drehteller aufgebrachte Substratscheibe, im dargestellten Fall eine Siliziumscheibe, durch Unterdruck in an sich bekannter Weise fixieren zu können. Die Drehscheibe 1 ist zusammen mit dem sie über eine dargestellte Welle antreibenden Motor 5 von einer Wandung 4 umgeben. Oberhalb des Drehtellers 1 ist ein geheizter Vorratsbehälter 6 mit Austrittsdüse 7 und darin integriertem Ventil 8 in nicht näher dargestellter Weise gehalten. Die Heizung des Vorratsbehälters kann wiederum in einfacher Weise über in seine Wandungen integrierte Heizspirale erfolgen. Auch die Düse und weitere nicht dargestellte Leitungen sind mit entsprechenden Heizeinrichtungen ausgestattet.

Wird der Drehteller 1 aufgeheizt, so heizt sich auch die durch Unterdruck fixierte Siliziumscheibe 3 mit den darin gegebenenfalls enthaltenen Strukturen und Ätzgruben auf. Abhängig vom Material wird die Heiztemperatur etwas oberhalb der Schmelztemperatur des Beschichtungsmaterials eingestellt. Bei einer durchgeführten Beschichtung mit flüssigem Zinn wurde die Heiztemperatur für den Vorratsbehälter 6 und den Drehteller 1 auf 250 C und damit knapp über dem Schmelzpunkt von Zinn (232 C) eingestellt. Bei einer glatten Siliziumoberfläche erfolgte die Beschichtung mit durch die Drehzahl vorgebbarer Dicke zumindest im zentralen Bereich des Wafers sehr gleichmäßig. Lediglich am Waferrand wurden etwas dickere Schichten festgestellt.

Grundsätzlich sind eine Vielzahl unterschiedlicher Substrate beschichtbar. Auf Oxiden oder Nitriden ist jedoch die Haftung schlechter als auf Silizium oder auf metallisierten Bereichen.

Wie bereits erwähnt, kann durch unterschiedliche Benetzungsbedingungen eine gezielte selektive Beschichtung der Oberfläche durchgeführt werden. Somit ist eine Oberflächenstrukturierung mit dem erfindungsgemäßen Verfahren möglich. Unterschiedliche Benetzungsbedingungen an der Substratoberfläche können durch unterschiedliche Materialien an der Substratoberfläche z.B. in Form von Oxid- oder Metallschichten erzielt werden.

Ferner ist eine durch die Oberflächenspannung bedingte Verteilung der flüssigen Schicht insbesondere in Kanälen zu beobachten, wobei Spitzen nicht beschichtet werden. Es konnten tiefe Kanäle von einer relativ zur Oberfläche gemessenen Tiefe bis zu 50 μm selektiv mit Metallschichten gefüllt werden. Durch Steuerung der Umdrehungszahl konnte der Füllungsgrad der Kanäle zwischen etwa 10 % und 90 % variiert werden.

**Patentansprüche**

1. Verfahren zur Beschichtung der Oberfläche von Substraten, insbesondere Silizium- oder anderen Halbleiterwafern dadurch gekennzeichnet,
daß ein Substrat, auf dessen Oberfläche wahlweise gleiche oder durch Vorsehen von Bereichen unterschiedlicher Haftung oder einer geometrischen Strukturierung unterschiedliche Benetzungs- und Beschichtungsbedingungen vorgegeben werden, auf dem Drehteller einer heizbaren Spin-Coatingapparatur fixiert wird,

daß geschmolzenes Material in der auf eine vorbestimmte Temperatur geheizten Spin-Coatingapparatur auf das auf dem geheizten Drehteller fixierte Substrat gebracht wird

und daß die Temperatur des Drehtellers nach erfolgter Ausbreitung des flüssigen Materials zur Hervorrufung einer Erstarrung des die Oberfläche vollständig oder durch die unterschiedlichen Bedingungen in bestimmten Bereichen selektiv beschichtenden Materials erniedrigt wird.

2. Verfahren nach Anspruch 1,
dadurch gekennzeichnet,
daß die Strukturierung in Form von in der Substratoberfläche ausgebildeten Kanälen oder andersartigen Vertiefungen vorgesehen wird, die durch diese Beschichtung selektiv mit einer Materialschicht bis zu einem vorgegebenen Grad gefüllt werden.

3. Verfahren nach Anspruch 1 oder 2,
dadurch gekennzeichnet,
daß als dieses Material ein geschmolzenes Metall auf das Substrat gebracht wird.

4. Verfahren nach einem der Ansprüche 1 und 3,
dadurch gekennzeichnet,
daß die Bereiche unterschiedlicher Haftung durch Beschichtungen mit verschiedenen Haftvermögen zu flüssigem Metall aus aus unterschiedlichen Materialien, insbesondere in Form von Oxiden, Nitriden oder Metallen an der Substratoberfläche vorgesehen werden.

5. Verfahren nach einem der vorhergehenden Ansprüche,
dadurch gekennzeichnet,
daß die Schichtdicke der Beschichtungen und der Füllungsgrad der Kanäle oder Vertiefungen unter Berücksichtigung der Oberflächenspannung der flüssigen Materialien bzw. Metalle und der Benetzungsverhältnisse durch Steuerung der Drehzahl des geheizten Drehtellers vorgegeben werden.

6. Verfahren nach einem der vorhergehenden Ansprüche,
dadurch gekennzeichnet,
daß die Temperatur der Spin-Coatingapparatur auf eine Temperatur über dem Schmelzpunkt des Materials aufgeheizt wird.

7. Vorrichtung zum Durchführen des Verfahrens nach einem der vorhergehenden Ansprüche, gekennzeichnet durch eine an sich bekannte Spin-Coatingapparatur, bei der ein Vorratsbehälter (6) für das Beschichtungsmaterial heizbar ist und die eine Heizeinrichtung für den Drehteller (1) aufweist.

Fig.1